# EUROPÄISCHE PATENTSCHRIFT

(11) **EP 1 588 598 B1**
(45) Veröffentlichungstag und Bekanntmachung des Hinweises auf die Patenterteilung: **24.05.2006**
(21) Anmeldenummer: 04701937.7
(22) Anmeldetag: 14.01.2004
(51) Int. Cl.: H05K 13/04

(54) **BESTÜCKKOPF MIT GREIFERN FÜR ELEKTRISCHE BAUELEMENTE**
ASSEMBLY HEAD COMPRISING GRIPPERS FOR ELECTRICAL COMPONENTS
TETE DE MISE EN PLACE DE COMPOSANTS COMPRENANT DES GRIFFES DESTINEES A DES COMPOSANTS ELECTRIQUES

(30) Priorität: 28.01.2003 DE 10303261
(43) Veröffentlichungstag der Anmeldung: 26.10.2005
(73) Patentinhaber: SIEMENS AKTIENGESELLSCHAFT, 80333 München (DE)
(72) Erfinder: MEHDIANPOUR, Mohammad, 81829 München (DE)
(86) Internationale Anmeldenummer: PCT/EP2004/000219
(87) Internationale Veröffentlichungsnummer: WO 2004/068926

(56) Entgegenhaltungen:
- US-A1- 2002 053 134
- US-B1- 6 176 007

## Beschreibung

Die Erfindung bezieht sich auf einen Bestückkopf mit Greifern für elektrische Bauelemente, wobei die senkrecht zu einer Arbeitsebene bewegbaren Greifer einzeln mit einem gemeinsamen Hubantrieb koppelbar sind.

Ein derartiger Bestückkopf ist zum Beispiel durch die WO 96/12394 A bekannt geworden. Die Greifer sind hier als längliche Saugrohre ausgebildet, die in einer Reihe hintereinander in paralleler Orientierung angeordnet angeordnet sind. Der Bestückkopf ist in einer Linearführung zwischen Zuführeinrichtungen für die Bauelemente und einer Leiterplatte verfahrbar, auf die die Bauelemente durch Absenken der Greifer in ihrer Längsrichtung aufgesetzt werden können. Die Greifer sind in einem senkrecht zur Leiterplatte auf und ab bewegbaren Hubkörper aufgenommen, der mittels eines Motors und eines Zahnriemens angetrieben werden kann.

Die unter axialer Federvorspannung stehenden Greifer sind durch schaltbare stationäre Anschläge des Bestückkopfs in ihrer oberen Hubstellung gehalten. Wird der Anschlag abgekoppelt, so werden die betreffenden Greifer freigegeben, wobei der Hubkörper die freigegebenen Greifer zunächst in ihrer oberen Stellung hält. Beim darauffolgenden Absenken des Hubkörpers werden die freigegebenen Greifer durch die Federkraft mitgenommen und definiert abgesenkt. Sind die Bauelemente an den Abholplätzen in Abstand der Greifer angeordnet, so ist es möglich, gleichzeitig mehrere Bauelemente durch gleichzeitiges Absenken mehrerer Greifer zu erfassen.

Beim Aufsetzen auf die Leiterplatte sind die Zielkoordinaten unregelmäßig verteilt, so dass ein gleichzeitiges Aufsetzen zweier Bauelemente kaum möglich ist. Das heißt, dass die Bauelemente in einzelnen aufeinanderfolgenden Hubzyklen aufgesetzt werden können, wobei jeder der Zyklen erst dann einsetzen kann, wenn der vorhergehende Greifer seine obere Einraststellung erreicht hat.

Der Erfindung liegt die Aufgabe zugrunde, die Zeitabstände zwischen den Zyklen zu verkürzen.

Diese Aufgabe wird durch die Erfindung gemäß Anspruch 1 gelöst. Durch den zweiten Hubantrieb ist es möglich, gleichzeitig zwei der Greifer mit je einem der Hubantriebe zu koppeln. Dadurch kann ein Greifer bereits abgesenkt werden, während sich der andere Greifer nach dem Aufsetzen seines Bauelements noch in der Aufwärtsbewegung befindet. Bei einer optimierten Bestückfolge sind die Verfahrwege des Bestückkopfs zwischen zwei Bestückvorgängen häufig so kurz, dass die Zykluszeit durch den Hubvorgang bestimmt wird. Durch die zeitliche Überlappung der Hubbewegungen ist es möglich, die Zyklussequenz entsprechend zu beschleunigen und die Bestückleistung des Bestückkopfes zu erhöhen. Es ist auch möglich, einen Bestückkopf z.B. mit einer großen Pipettenanzahl mit zusätzlichen voneinander unabhängigen Hubantrieben zu versehen, um mehrere gleichzeitig Greifer zu betätigen.

Vorteilhafte Weiterbildungen der Erfindung sind in den Ansprüchen 2 bis 9 gekennzeichnet:

Durch die getrennt steuerbaren Hubantriebe nach Anspruch 2 können die Hubvorgänge besonders effektiv miteinander verzahnt werden.

Durch die schaltbaren Koppelelemente nach den Ansprüchen 3 und 4 können die Greifer unmittelbar mit den Hubantrieben gekoppelt werden, wobei die Koppelelemente vorteilhaft nach Anspruch 5 an den Hubkörpern verankert sind.

Die Reibelemente nach Anspruch 6 können mit einer minimalen Koppelbewegung an die Greifer angelegt bzw. von diesen entkoppelt werden. Die spielfreie Kopplung ermöglicht eine exakte Hubsteuerung der Greifer.

Die Weiterbildung nach Anspruch 7 ermöglicht eine einfache Ausgestaltung und Montage der Federfinger.

Durch die Weiterbildung nach Anspruch 8 ist es möglich, die Koppelemente unmittelbar nebeneinander an den Greifer aus der gleichen Richtung anzusetzen, was den Raumbedarf verringert und eine entsprechend kompakte Bauweise des Bestückkopfes ermöglicht.

Durch den Linearmotor nach Anspruch 9 können die Hubkörper unmittelbar präzise angetrieben werden.

Im Folgenden wird die Erfindung anhand des in der Zeichnung dargestellten Ausführungsbeispieles näher erläutert.
- Figur 1: zeigt in einer Seitenansicht einen Bestückkopf mit einer Reihe von zueinander parallelen Greifern für elektrische Bauelemente,
- Figur 2: eine Stirnansicht des Bestückkopfs nach Figur 1 mit einem Teilschnitt entlang der Linie II-II in Figur 1,
- Figur 3: eine Draufsicht auf dem Bestückkopf nach Figur 2,
- Figur 4: die Stirnansicht nach Figur 2 mit einem anderen Teilschnitt entlang der Linie IV-IV in Figur 1.

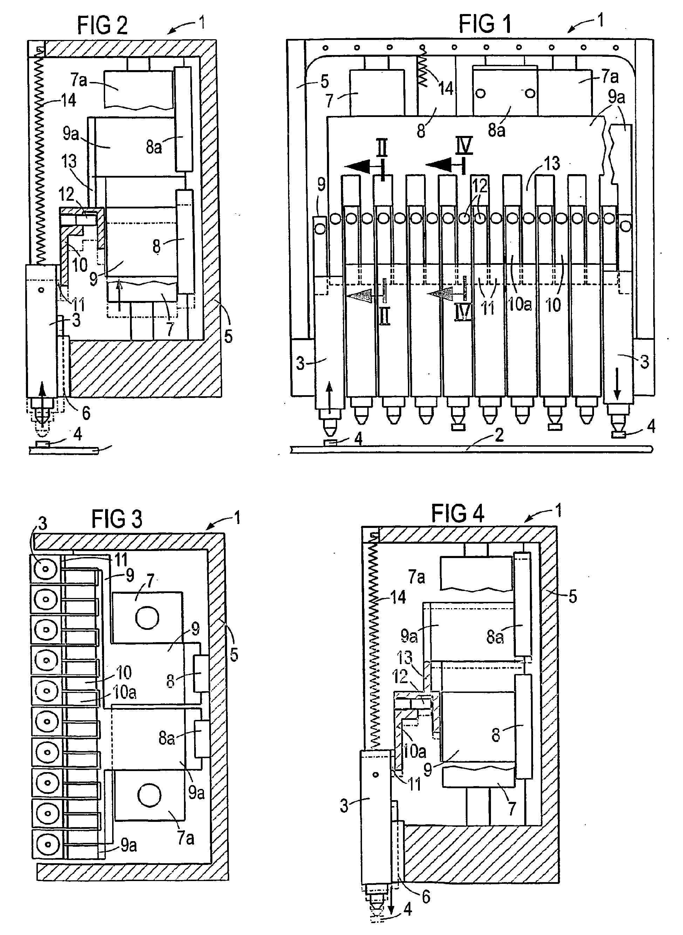

Nach den Figuren 1, 2 und 3 ist ein Bestückkopf 1 einer nicht näher dargestellten Bestückvorrichtung über einer in der Bestückvorrichtung fixierten Leiterplatte 2 angeordnet, deren Oberfläche eine Arbeitsebene definiert. Der Bestückkopf relativ zur Leiterplatte parallel zu dieser bewegbar ist. Er ist mit länglichen, senkrecht zur Arbeitsebene stehenden Greifern 3 versehen, an deren unteren Enden elektrische Bauelemente 4 in einem Zuführbereich der Bestückvorrichtung angesaugt werden können. Der Bestückkopf 1 verfährt parallel zur Arbeitsebene über die Leiterplatte 2 und setzt die angesaugten Bauelemente 4 sukzessive auf diese auf.

Die Greifer 3 sind in einem kastenartigen Gehäuse 5 des Bestückkopfs 1 aufgenommen und in zugehörigen linearen Führungen 6 einzeln zur Leiterplatte 2 hin absenkbar. Dies geschieht mit Hilfe eines ersten, für alle Greifer 3 gemeinsamen Hubantriebs, der aus einem ersten Linearantrieb 7, einer ersten Linearführung 8, einem ersten Hubkörper 9 mit ersten schaltbaren Koppelelementen 10 gebildet ist, die über Reibelemente 11 gegen die oberen Greiferenden drückbar sind. Der Hubkörper 9 ist fest mit dem ersten Linearantrieb 7 verbunden. Die Linearführung 8 erstreckt sich parallel zur linearen Führung 6 der Greifer 3. Die ersten Koppelemente 10 sind als kammartig freigeschnittene bügelartige Federzungen ausgebildet, die sich im wesentlichen parallel zur Hubrichtung erstrecken und in die Nähe der oberen Greiferenden ragen. Im Fußbereich der Federzungen sind einzeln betätigbare piezoelektrische Aktoren angeordnet, durch die Schenkel der Koppelelemente 10 auseinandergespreizt und die unteren Enden der Federzungen gegen die Greifer 3 gedrückt werden können, um so den Hubantrieb rutschfest mit dem jeweiligen Greifer zu koppeln. Im unbetätigten Zustand der Aktoren 12 sind die Reibelemente kraftfrei von den Greifern 3 entkoppelt.

Der zweite Hubantrieb ist durch einen zweiten Linearmotor 7a eine zweite Linearführung 8a, einen zweiten Hubkörper 9a und ein zweites Koppelelement 10a gebildet, und über weitere Reibelemente 11 in ähnlicher Weise wie der erste Hubantrieb mit den Greifern 3 koppelbar. Dabei sind die Koppelelemente 10 und 10a so schmal gehalten, dass jeweils eines der ersten Koppelelemente 10 und eines der zweiten Koppelelemente 10a nebeneinander an einen der Greifer 3 anlegbar sind. Der zweite Hubkörper 9a befindet sich hier oberhalb des ersten Hubkörpers 9 und ragt mit einstückig angesetzten fingerartigen Fortsätzen 13 zwischen die ersten Koppelelemente 10 des ersten Hubkörpers 9, wobei die Fortsätze 13 die zweiten Koppelelemente 10a tragen.

Die Greifer 3 sind durch Zugfedern 14 und nicht näher dargestellte Anschläge in einer definierten oberen Ausgangsstellung gehalten. Nach Figur 1 befindet sich der äußere linke Greifer 3 gemäß dem zugeordneten Aufwärtspfeil in einer Aufwärtsbewegung unmittelbar nach dem Aufsetzen seines Bauelements 4 auf die Leiterplatte 2. Diese Stellung ist durch die strichpunktierten Linien in Figur 2 angedeutet. Der Greifer ist durch Betätigung des zugehörigen Aktors 12 mit dem ersten Hubkörper 9 gekoppelt, der mittels des ersten Linearmotors abgesenkt wurde und sich zur oberen Ausgangsstellung hin bewegt. Der äußere rechte Greifer 3 ist in einer Phase dargestellt in der er mittels eines anderen Aktors 12 mit dem zweiten Hubkörper 9a gekoppelt ist. Dieser hat bereits seine obere Ausgangsstellung verlassen hat und befindet sich in einer anfänglichen Abwärtsbewegung, durch die der zugehörige Greifer 3 mit einem der angesaugten Bauelemente 4 entsprechend dem zugeordneten Bewegungspfeil zur Leiterplatte 2 hin abgesenkt wird. Diese Stellung ist in Figur 4 durch die strichpunktierten Linien dargestellt. Da dieser Vorgang eingeleitet wird, bevor der vorangehende Greifer 3 mit erreichen der oberen Ausgangstellung seinen Arbeitszyklus beendet hat, kann der Zyklustakt verkürzt und die Bestückleistung erhöht werden. Nach dem Aufsetzen des äußersten rechten Bauelements 4 auf die Leiterplatte 2 kann ein weitere Greifer 3 bereits mit dem ersten Hubkörper gekoppelt und abgesenkt werden.

### Bezugszeichenliste

- 1: Bestückkopf
- 2: Leiterplatte
- 3: Greifer
- 4: Bauelement
- 5: Gehäuse
- 6: Führung
- 7: erster Linearmotor
- 7a: zweiter Linearmotor
- 8: erste Linearführung
- 8a: zweite Linearführung
- 9: erster Hubkörper
- 9a: zweiter Hubkörper
- 10: erstes Koppelelement
- 10a: zweites Koppelelement
- 11: Reibelement
- 12: Aktor
- 13: Fortsatz
- 14: Zugfeder

## Patentansprüche

1. Bestückkopf (1) mit Greifern (3) für elektrische Bauelemente (4), wobei die senkrecht zu einer Arbeitsebene bewegbaren Greifer (3) einzeln mit einem gemeinsamen ersten Hubantrieb (7, 8, 9, 10) koppelbar sind,
**dadurch gekennzeichnet,**
**dass** der Bestückkopf (1) mit einem zweiten, unabhängig vom ersten betätigbaren Hubantrieb (7a, 8a, 9a, 10a) versehen ist und dass die Greifer (3) wahlweise mit dem einen oder anderen Hubantrieb koppelbar sind.

2. Bestückkopf nach Anspruch 1,
**dadurch gekennzeichnet,**
**dass** einer der getrennt steuerbaren Hubantriebe mit zumindest einem der angekoppelten Greifer (3) aus einer Ausgangsstellung zur Arbeitsebene hin absenkbar ist, bevor der zuvor abgesenkte andere Hubantrieb mit zumindest einem anderen der Greifer (3) seine Ausgangsstellung erreicht hat.

3. Bestückkopf nach Anspruch 1 oder 2,
**dadurch gekennzeichnet,**
**dass** die Hubantriebe mit einem ersten Hubkörper (9) bzw. einem zweiten Hubkörper (9a) versehen sind, der sich in die Nähe der Greifer (3) erstreckt und
**dass** die einzelnen Greifer (3) mittels schaltbarer erster Koppelelemente (10) bzw. zweiter Koppelemente (10a) mit beiden Hubantrieben koppelbar sind.

4. Bestückkopf nach Anspruch 3,
**dadurch gekennzeichnet,**
**dass** für jeden der Greifer (3) zwei getrennte Koppelelemente (10, 10a) für die beiden Hubantriebe vorgesehen sind.

5. Bestückkopf nach Anspruch 3 oder 4,
**dadurch gekennzeichnet,**
**dass** die Koppelemente (10, 10a) an den Hubkörpern (9, 9a) verankert sind.

6. Bestückkopf nach Anspruch 5,
**dadurch gekennzeichnet,**
**dass** die Koppelelemente (10, 10a) federnd auslenkbare Reibelemente (11) aufweisen, die mittels schaltbarer Aktoren (12) reibschlüssig mit den Greifern (3) verbindbar sind.

7. Vorrichtung nach Anspruch 5 oder 6,
**dadurch gekennzeichnet,**
**dass** die Koppelelemente (10, 10a) als einstückig mit den Hubkörpern (9, 9a) verbundene kammartig abstehende Federfinger ausgebildet sind, an deren freien Enden die Reibelemente (11) angeordnet sind.

8. Bestückkopf nach Anspruch 7,
**dadurch gekennzeichnet,**
**dass** die Hubkörper (9, 9a) im Bestückkopf (1) einander benachbart sind und
**dass** die Federfinger des einen Hubkörpers (9) in die Lücken zwischen den Federfingern des anderen Hubkörpers (9a) ragen.

9. Bestückkopf nach einem der vorhergehenden Ansprüche,
**dadurch gekennzeichnet,**
**dass** die Hubkörper (9, 9a) jeweils mit einem Linearmotor (7, 7a) des Hubantriebs gekoppelt sind.

## Claims

1. Placement head (1) having grippers (3) for electrical components (4), wherein the grippers (3), which are movable perpendicular to a plane of operation, can be coupled individually to a common first lifting drive (7, 8, 9, 10),
**characterised in that**
the placement head (1) is provided with a second lifting drive (7a, 8a, 9a, 10a) which can be actuated independently of the first, and that the grippers (3) can optionally be coupled to the one or other lifting drive.

2. Placement head according to claim 1,
**characterised in that**
one of the separately controllable lifting drives can be lowered with at least one of the coupled grippers (3) from a starting position towards the plane of operation before the previously lowered other lifting drive with at least another of the grippers (3) has returned to its starting position.

3. Placement head according to claim 1 or 2,
**characterised in that**
the lifting drives are provided with a first lifting body (9) or a second lifting body (9a) which extends into the vicinity of the grippers (3) and
**that** the individual grippers (3) can be coupled to the two lifting drives by means of switchable first coupling elements (10) or second coupling elements (10a) .

4. Placement head according to claim 3,
**characterised in that**
for each of the grippers (3) two separate coupling elements (10, 10a) are provided for the two lifting drives.

5. Placement head according to claim 3 or 4,
**characterised in that**
the coupling elements (10, 10a) are anchored to the lifting bodies (9, 9a).

6. Placement head according to claim 5,
**characterised in that**
the coupling elements (10, 10a) have friction elements (11) which can be deflected by means of a spring action and which can be connected to the grippers (3) in a friction-fit manner by means of switchable actuators (12).

7. Device according to claim 5 or 6,
**characterised in that**
the coupling elements (10, 10a) are embodied as spring tabs projecting in a comb-like manner and connected to the lifting bodies (9, 9a) as a single piece, the friction elements (11) being arranged at the free ends of said spring tabs.

8. Placement head according to claim 7,
**characterised in that**
the lifting bodies (9, 9a) are adjacent to one another in the placement head (1) and
the spring tabs of the one lifting body (9) project into the gaps between the spring tabs of the other lifting body (9a).

9. Placement head according to one of the preceding claims,
**characterised in that**
the lifting bodies (9, 9a) are each coupled to a linear motor (7, 7a) of the lifting drive.

## Revendications

1. Tête de mise en place (1) dotée de pinces (3) pour des composants électriques (4), les pinces (3) qui peuvent être déplacées perpendiculairement à un plan de travail pouvant être accouplées individuellement à un premier entraînement de relèvement commun (7, 8, 9, 10),
**caractérisée en ce que**
la tête de mise en place (1) est dotée d'un deuxième entraînement de relèvement (7a, 8a, 9a, 10a) qui peut être actionné indépendamment du premier et **en ce que** les pinces (3) peuvent être accouplées sélectivement à l'un ou à l'autre entraînement de relèvement.

2. Tête de mise en place selon la revendication 1, **caractérisée en ce que** l'un des entraînements de relèvement commandés séparément peut être abaissé avec au moins l'une des pinces (3) accouplées vers le plan de travail et depuis une position initiale avant que l'autre entraînement précédemment abaissé avec au moins une autre des pinces (3) ait atteint sa position initiale.

3. Tête de mise en place selon la revendication 1 ou 2, **caractérisée en ce que** les entraînements de relèvement sont dotés d'un premier corps de relèvement (9) resp. d'un deuxième corps de relèvement (9a) qui s'étend à proximité des pinces (3) et **en ce que** les pinces individuelles (3) peuvent être accouplées aux deux entraînements de relèvement au moyen de premiers éléments d'accouplement (10) resp. de deuxièmes éléments d'accouplement (10a) commutables.

4. Tête de mise en place selon la revendication 3, **caractérisée en ce que** deux éléments d'accouplement (10, 10a) séparés sont prévus pour les deux entraînements de relèvement de chacune des pinces (3).

5. Tête de mise en place selon la revendication 3 ou 4, **caractérisée en ce que** les éléments d'accouplement (10, 10a) sont ancrés sur les corps de relèvement (9, 9a).

6. Tête de mise en place selon la revendication 5, **caractérisée en ce que** les éléments d'accouplement (10, 10a) présentent des éléments de frottement (11) qui peuvent être écartés élastiquement et qui peuvent être reliés aux pinces (3) par frottement au moyen d'actionneurs (12) commutables.

7. Dispositif selon la revendication 5 ou 6, **caractérisé en ce que** les éléments d'accouplement (10, 10a) sont configurés sous la forme de doigts élastiques reliés d'un seul tenant aux corps de relèvement (9, 9a) et en saillie en forme de peigne, les éléments de frottement (11) étant disposés à leur extrémité libre.

8. Tête de mise en place selon la revendication 7, **caractérisée en ce que** les corps de relèvement (9, 9a) sont voisins l'un de l'autre dans la tête de mise en place (1) et **en ce que** les doigts élastiques de l'un des corps de relèvement (9) s'enfoncent dans les interstices entre les doigts élastiques de l'autre corps de relèvement (9a).

9. Tête de mise en place selon l'une des revendications précédentes, **caractérisée en ce que** chaque corps de relèvement (9, 9a) est accouplé à un moteur linéaire (7, 7a) de l'entraînement de relèvement.
